(19)

Europäisches
Patentamt
European
Patent Office
Office européen
des brevets

(11) **EP 4 293 849 A1**

(12) **EUROPEAN PATENT APPLICATION**

(43) Date of publication:
**20.12.2023 Bulletin 2023/51**

(21) Application number: **22178952.2**

(22) Date of filing: **14.06.2022**

(51) International Patent Classification (IPC):
**H02J 3/00** *(2006.01)*        **H02J 13/00** *(2006.01)*
**H02J 3/14** *(2006.01)*

(52) Cooperative Patent Classification (CPC):
**H02J 3/001; H02J 3/14; H02J 13/0002;**
**H02J 13/0004;** H02J 2310/44; H02J 2310/52;
H02J 2310/60

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Collins Aerospace Ireland, Limited**
**T23 XN53 Cork City (IE)**

(72) Inventors:
• **TORCHIO, Marcello**
  **Cork, T12 XE72 (GB)**
• **RIVERSO, Stefano**
  **Cork, T23 F409 (GB)**

(74) Representative: **Dehns**
  **St. Bride's House**
  **10 Salisbury Square**
  **London EC4Y 8JD (GB)**

(54) **METHOD TO DETECT OVERLOAD RESOLUTIONS FOR AIRCRAFT ENERGY MANAGEMENT SYSTEMS**

(57)     A method for identifying and managing a power overload condition of devices located in a power network of an environment is described herein. The method comprises, via a controller, accessing and receiving a plurality of measurements from a plurality of devices and/or locations within the environment, detecting an overall overload condition on said plurality of devices, and if said overload condition is detected, actuating, or controlling a power consumption of said one or more devices, such that said overload condition is reduced, and said method further comprising, via said controller, monitoring said overload condition and automatically detecting when said overload condition has cleared.

EP 4 293 849 A1

**Description**

**TECHNICAL FIELD**

The methods described herein relate to detecting power overload in aircraft energy management systems.

**BACKGROUND**

The aerospace industry is moving towards the More Electric Aircraft (MEA) paradigm from different perspectives. One of the beaten paths involves the adoption of more sophisticated Power and Energy Management Systems (PEMSs) to enable the smart and optimized management of onboard available power and counteract with appropriate actions in the presence of possible generators' failures and overload conditions.

An overload condition may occur as the result of an overall extra load that is connected to the aircraft power network, or because of failures acting over one (or more) generators with the result of being unable to fully support the power and energy demand. The time at which an overload condition appears, and the amount of power it requires are unknown a priori.

**SUMMARY**

A method for identifying and managing a power overload condition of devices located in a power network of an environment is described herein, the method comprising, via a controller, accessing and receiving a plurality of measurements from a plurality of devices and/or locations within the environment, detecting an overall overload condition on said plurality of devices, and if said overload condition is detected, actuating, or controlling a power consumption of said one or more devices, such that said overload condition is reduced, and said method further comprising, via said controller, monitoring said overload condition and automatically detecting when said overload condition has cleared.

The step of detecting an overall overload condition on said plurality of devices may comprise a threshold analysis.

The threshold analysis may comprise detecting that an overall measured power of one or more of said plurality of devices is greater than an overall power threshold.

The method may comprise, following said step of detecting said overload condition, via said controller, managing said overload by reducing the overall power consumption on said plurality of devices to a set level.

The step of reducing the overall power consumption may comprise, via said controller, operating said plurality of devices at a power level lower than a rated power level.

The step of operating said plurality of devices at a power level lower than a rated power level may comprise reducing power to said plurality of devices.

The step of operating said plurality of devices at a power level lower than a rated power level may comprise providing power to said network from power storage systems.

The step of managing said overload may comprise, via said controller, driving one or more of said plurality of devices to support said overload condition.

The said step of driving said one or more plurality of devices may comprise computing a control action value u(t), wherein said control action value $u(t)$ represents a power that said device requires to support said overload condition, and, via said controller, controlling said device through the computation of u(t).

The step of detecting said overload condition may comprise detecting when said value of $u(t)$ is greater than a minimum allowed value $u_{min}$ and less than or equal to a maximum value $u_{max}$.

The step of automatically detecting when said overload condition has cleared may comprise detecting that said value of $u(t)$ is tending to, or has reached, a minimum value.

In any of the examples described herein, if said overload condition has been detected, the method may comprise, controlling, via said controller, said plurality of devices, such that they operate below, or up to, a maximum value.

The environment may be an aircraft. The methods may also be used in other environments.

A controller may be configured to perform any of the methods described herein.

In some examples, the controller may comprise a Proportional Integral "PI" controller. Other controllers may also be used.

The power network may have a physical architecture and said step of automatically detecting when said overload has cleared may further comprise restoring nominal operating conditions over the power network, without any dependency over the physical architecture of the said power network, nor detailed information of the devices used to support and resolve the said overload condition.

## DETAILED DESCRIPTION

One of the main aims of an innovative power and energy management system (PEMS), such as those used in aircraft, is to provide monitoring (e.g., overload detection, failures detection, etc.), coordination and control capabilities to detect and resolve - as fast as possible - any overload condition that may affect the aircraft power network. The ability of a PEMS to resolve an overload condition by controlling (i.e., chopping or shedding) loads, can provide a more compact design of the generators with positive impact over their sizing and weight.

A PEMS should support the management and clearance of an overload condition through the coordination of suitable energy and power devices present on the aircraft network, e.g. electrical storage systems (such as batteries, supercapacitors, etc.), thermal storage systems (e.g. fridges, Environmental Control System, etc.), programmable loads (e.g. LEDs, Inflight Entertainment System, etc.), etc.

Once the source of the overload (e.g., an unexpected extra load acting on the power network) disappears, the PEMS shall ensure also to:

1. properly detect the detachment of the overload source, and
2. ensure the recovery of the aircraft power network back to its normal conditions (i.e., restore the working condition all those energy and power devices that were controlled to manage the overload).

Most of the available literature solutions for PEMS rely on the definition of tailored rules that fit a specific scenario or power network architecture.

The methods described herein can be used to detect the presence of an overload condition, manage energy and power devices to bring the generators power within safe operational bounds, and identify when the source of such condition is not anymore acting over the aircraft power network (i.e., clearance of the overload condition). The proposed methods do not rely over specific power network architectures, nor tailored sets of rules to perform such actions. Indeed, the proposed methods are generic. The methods can be performed by a controller that is configured to deliver such actions. The methods may take measurements from different devices and/or locations within the aircraft, or, if not used in an aircraft, different devices and/or locations within the environment that is being monitored. The proposed methodology applies to generic power networks that may suffer of similar issues as the ones described in the introduction of this document and are not limited only to use in an aircraft.

For the method to be performed, the controller may be configured to access and receive (but not limited to) a measurement or plurality of measurements from one or more devices and/or locations within the environment, e.g., aircraft. Measurements may be obtained by each single device, a subset of them, or a combination of single measurements and plurality of them. The controller may also be configured to actuate or control the power consumption of one or more power loads of the devices of the environment, e.g., aircraft.

The controller is configured to automatically identify the presence of an overload condition on the one or more generators. Such an overload condition may occur if e.g., the generators of the aircraft are operating above their rated power, such that there is too great a power load on the devices overall. If the controller detects that an overload condition has occurred, in some examples, the controller may be configured to send a warning signal to the user. This phase is called "overload detection phase".

The overload detection phase can be achieved based on threshold analysis, e.g., checking if the condition $Power_{generator}(t) > Power_{threshold}(t)$ holds true. In particular:

- $t$ is the discrete time instant,
- $Power_{generator}(t)$ is the overall measured power of the Aircraft generator(s), and
- $Power_{threshold}(t)$ can be a time-varying (or static) threshold value that is used to identify the presence of an overload.

After the overload detection phase takes place, the controller may enter the "overload management phase". In particular, the controller may be configured to deal with it in an integrated way, so as to reduce the overall power consumption to a safe level by keeping generators operating below their rated power. This objective may be achieved through the modulation (i.e. reduction) of power consumption of the different controllable energy and power devices connected to the aircraft power network by means of the controller itself. Order and criterion through which energy and power devices are modulated may vary case by case, based on specific design requirements. During this phase, the source of overload is still present within the aircraft power network, but the controller acts in such a way to keep safe operations on the aircraft power network. If storage systems are part of the power network, they may be coordinated by the PEMS to yield power to the network, such to reduce the power requested from the generators.

In some examples, a Proportional Integral (PI) controller may be used during this phase. Other controllers may alternatively be used, and the methods described herein are not limited to this one type.

The method may comprise the controller computing a control action value $u(t)$ to drive a specific energy device to support an overload condition. The value *u(t)* represents the power consumption that a specific power or energy device (e.g., storage system) must modulate (e.g., reduce) to support an overload condition. Using an aggregate of load measurements taken from a plurality of devices and/or locations within the environment, the basic PI controller may compute *u(t)* in the following way:

## Equation 1

$$u(t) = K_p \cdot e(t) + K_I \cdot z(t), \ u(t) \in [u_{min}; u_{max}]$$
$$z(t + 1) = z(t) + \Delta T \, e(t), \qquad z(0) = 0$$

Where:

- $K_p$ is the proportional gain of the controller,
- $K_I$ is the integral gain of the controller,
- $e(t)$ is the controller error,
- $z(t)$ is the integrator of the controller,
- $\Delta T$ is the controller sampling time, and
- $t$ represents the discrete time instant.

The above controller implements saturation on *u(t)* to account for energy and power devices actuation limits and considers the presence of antiwindup configurations.
The controller error may be computed as:

$$e(t) = Power_{generator}(t) - Power_{reference}(t)$$

where:

- $Power_{generator}(t)$ is the measured power of the generator(s), and
- $Power_{reference}(t)$ is a reference value to drive the generators to work below their rated value.

Note that for the specific control problem it must hold that

$$Power_{reference}(t) \le Power_{generator}(t), \forall \, t.$$

For safety reasons, a safe operational band is considered during overload management phase.

$$Power_{reference}(t) < Power_{generator}(t), \forall \, t$$

Moreover, it may be common to choose $Power_{reference}(t) < Power_{threshold}(t), \forall t.$
The method may further comprise, when an overload is detected, controlling the energy device through the computation of *u(t)* to ensure the minimization of the error e(t).
In known devices and methods, it has proved difficult to identify an overload condition. Known devices and methods also do not identify when the overload condition has cleared. The methods described herein, however, allow the controller to automatically characterise an overload condition, such that the overload condition is automatically detected, managed, and the clearance of the overload condition is also detected. Due to this, the methods described herein do not compromise the safety of the environment in which they are performed.
When the source of overload disappears from the aircraft power network, the controller enters the "overload recovery phase", through which it restores all the different power and energy devices to their operating conditions as it was before the overload took place. This phase ensures to restore the working state of the services delivered by the aircraft power network before the overload took place. After the devices are all restored to their pre-overload working conditions, the controller enters an "idle and monitoring phase" where it monitors the aircraft power network status for further overload conditions.
**Condition 1:** If an overload condition is acting on the power network, the value of ***u(t)*** will be **strictly greater** than its minimum allowed value $u_{min}$ and **less or equal** to its maximum $u_{max}$.

However, thanks to the integral term z(t) in Equation 1, the value of $u(t)$ will tend back to its minimum (and will reach eventually that value) **if and only if** the generators' power fall under the reference of the controller. This condition would represent a scenario in which the source of overload condition has disappeared.

For sake of simplicity, this example relates to one power or energy device controlled to support an overload condition. However, the proposed method can scale to a plurality of controlled energy or power devices, if Condition 1 is verified for all the involved energy or power devices participating to the "overload management phase".

In some examples, a time-based (or filters) check could be added to make sure that the fall of the generators' power is not due to some noise.

A more complex situation may take place if the generators power - right before an overload was detected - felt in the following interval:

$$Power_{reference} < Power_{generator}(t) \leq Power_{treshold}$$

Indeed, it may happen that (in absence of overload conditions) the generators operate in between the power reference value and the threshold quantity. This could happen because, for instance, high-load condition of the network is experienced.

If a source of overload is added on top of the above operating condition, the PEMS will enter into the "overload management phase" and handle the situation according to **Error! Reference source not found..** In principle, after the source of the overload disappears, the generators power should go back and operate in the aforementioned interval.

However, this won't be the case, as the PI controller in Equation 1 will keep computing $u(t)$ to maintain generators' power as close as possible to the reference value. This will prevent the possibility to $u(t)$ to reach $u_{min}$ and therefore determine the clearance of the overload by the PEMS as described in Condition 1.

If this happens, the PEMS may check the following condition:

- 

$$Power_{generator}(t) + u(t) < Power_{threshold}$$

If the above condition is true, it means that the deactivation of the power or energy device will not lead the generator to operate above the overload threshold. Therefore, if the condition is verified, the computation of the error in Equation 1 may be modified as follows:

- 

$$e(t) = Power_{generator}(t) - Power_{threshold}$$

Thanks to this modification, the controller in Equation 1 will now try to push the generators power towards the threshold (which is a higher value) and thus will reduce the value of $u(t)$ down to its minimum. This will allow the PEMS to identify the clearance of the overload condition.

The methods described herein provide a controller that allows to easily identify presence of overload acting over an aircraft power network, manage the transient condition, and detect the overload's clearance. This approach provides a scalable way to tackle this problem and it's not tailored for specific applications (as usually done in known systems) but covers different possible situations.

**Claims**

1. A method for identifying and managing a power overload condition of devices located in a power network of an environment, the method comprising, via a controller,

   accessing and receiving a plurality of measurements from a plurality of devices and/or locations within the environment,
   detecting an overall overload condition on said plurality of devices, and if said overload condition is detected, actuating, or controlling a power consumption of said one or more devices, such that said overload condition is reduced,
   and said method further comprising, via said controller, monitoring said overload condition and automatically detecting when said overload condition has cleared.

2. The method of claim 1 wherein said step of detecting an overall overload condition on said plurality of devices comprises a threshold analysis.

3. The method of claim 2 wherein said threshold analysis comprises detecting that an overall measured power of one or more of said plurality of devices is greater than an overall power threshold.

4. The method of any preceding claim wherein, following said step of detecting said overload condition, the method further comprises, via said controller, managing said overload by reducing the overall power consumption on said plurality of devices to a set level.

5. The method of claim 4 wherein said step of reducing the overall power consumption comprises, via said controller, operating said plurality of devices at a power level lower than a rated power level.

6. The method of claim 5 wherein said step of operating said plurality of devices at a power level lower than a rated power level comprises reducing power to said plurality of devices.

7. The method of claim 5 or 6 wherein said step of operating said plurality of devices at a power level lower than a rated power level comprises providing power to said network from power storage systems.

8. The method of any of claims 4 to 7 wherein said step of managing said overload comprises, via said controller, driving one or more of said plurality of devices to support said overload condition.

9. The method of claim 8 wherein said step of driving said one or more plurality of devices comprises computing a control action value u(t), wherein said control action value $u(t)$ represents a power that said device requires to support said overload condition, and, via said controller, controlling said device through the computation of u(t).

10. The method of claim 9, wherein said step of detecting said overload condition comprises detecting when said value of $u(t)$ is greater than a minimum allowed value $u_{min}$ and less than or equal to a maximum value $u_{max}$.

11. The method of claim 8 or 9, wherein said step of automatically detecting when said overload condition has cleared comprises detecting that said value of $u(t)$ is tending to, or has reached, a minimum value.

12. The method of any preceding claim, comprising, if said overload condition has been detected, controlling, via said controller, said plurality of devices, such that they operate below, or up to, a maximum value.

13. The method of any preceding claim wherein said environment is an aircraft.

14. A controller configured to perform the method of any preceding claim.

15. The controller of any preceding claim wherein said controller comprises a Proportional Integral "PI" controller.

Europäisches
Patentamt

European
Patent Office

Office européen
des brevets

# EUROPEAN SEARCH REPORT

Application Number

**EP 22 17 8952**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/152942 A1 (WAITE BENJAMIN D [US] ET AL) 18 June 2009 (2009-06-18) | 1-6,8-15 | INV. H02J3/00 |
| Y | * paragraphs [0001], [0025] – [0030], [0034]; figures 1,2 * | 7 | H02J13/00 H02J3/14 |
| X | US 11 183 843 B1 (COOPER J CARL [US]) 23 November 2021 (2021-11-23) | 1 | |
| Y | * figures 4,5,12 * | 7 | |
| X | US 10 879 727 B1 (COOPER JAMES CARL [US]) 29 December 2020 (2020-12-29) * figures 4,5 * | 1 | |

TECHNICAL FIELDS SEARCHED (IPC)

**H02J**

The present search report has been drawn up for all claims

| Place of search | Date of completion of the search | Examiner |
|---|---|---|
| Munich | 23 November 2022 | Ramcke, Ties |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

**EP 22 17 8952**

This annex lists the patent family members relating to the patent documents cited in the above-mentioned European search report.
The members are as contained in the European Patent Office EDP file on
The European Patent Office is in no way liable for these particulars which are merely given for the purpose of information.

**23-11-2022**

| Patent document cited in search report | | | Publication date | Patent family member(s) | | | Publication date |
|---|---|---|---|---|---|---|---|
| US 2009152942 | A1 | | 18-06-2009 | EP | 2220741 | A2 | 25-08-2010 |
| | | | | US | 2009152942 | A1 | 18-06-2009 |
| | | | | US | 2012146405 | A1 | 14-06-2012 |
| | | | | WO | 2009082595 | A2 | 02-07-2009 |
| US 11183843 | B1 | | 23-11-2021 | NONE | | | |
| US 10879727 | B1 | | 29-12-2020 | US | 10879727 | B1 | 29-12-2020 |
| | | | | US | 10892618 | B1 | 12-01-2021 |

EPO FORM P0459

For more details about this annex : see Official Journal of the European Patent Office, No. 12/82